(19) **Europäisches Patentamt**

**European Patent Office**

**Office européen des brevets**

(11) Veröffentlichungsnummer: **0 393 588**

**A2**

(12) **EUROPÄISCHE PATENTANMELDUNG**

(21) Anmeldenummer: **90107263.7**

(22) Anmeldetag: **17.04.90**

(51) Int. Cl.⁵: **H05K 13/00**

(30) Priorität: **17.04.89 DE 3912590**

(43) Veröffentlichungstag der Anmeldung:
**24.10.90 Patentblatt 90/43**

(84) Benannte Vertragsstaaten:
**CH DE FR GB LI**

(71) Anmelder: **Willberg, Hans-Heinrich**
**Malerwinkelweg 23**
**D-8201 Altofing/Bad Feilnbach(DE)**

(72) Erfinder: **Willberg, Hans-Heinrich**
**Malerwinkelweg 23**
**D-8201 Altofing, Bad Feilnbach(DE)**
Erfinder: **Baumgartner, Helmut**
**Am Hirschbichl 6**
**D-8200 Rosenheim(DE)**

(74) Vertreter: **Schmidt-Evers, Jürgen, Dipl.-Ing. et al**
**Patentanwälte Dipl.-Ing. H. Mitscherlich**
**Dipl.-Ing. K. Gunschmann Dipl.-Ing.**
**Dr.rer.nat. W. Körber Dipl.-Ing. J.**
**Schmidt-Evers Dipl.-Ing. W. Melzer**
**Steinsdorfstrasse 10**
**D-8000 München 22(DE)**

(54) **Gerät zum Beladen und/oder Entladen von elektronischen Bauelementen, insbesondere IC's, auf oder von Trägern.**

(57) Ein Gerät (3) zum Beladen und/oder Entladen von Trägern (14) mit elektronischen Bauelementen (3), insbesondere IC's, ist so auszugestalten, daß bei Gewährleistung einer hohen Durchlaufleistung ein störungsfreier Durchlauf ohne eine Abhängigkeit der Ein- und Ausgangshöhen möglich ist. Dies wird dadurch erreicht, daß eine erste Greifvorrichtung (4) mit einem Greifer (5) vorgesehen ist, die im Beladebetrieb zur Aufnahme eines Bauelements (3) an einer Aufnahmestelle (7) und Förderung sowie Bereithaltung des Bauelements (3) an einer Übergabestelle (8) dient, und daß eine zweite Greifvorrichtung (9) mit einem Greifer (11) vorgesehen ist, die im Beladebetrieb zur Übernahme des Bauelements (3) an der Übergabestelle (8) sowie Förderung und Abgabe des Bauelements (3) an einen an der Abgabestelle (12) bereitgestellten Träger (14) dient.

FIG. 1

EP 0 393 588 A2

Die Erfindung bezieht sich auf ein Gerät nach dem Oberbegriff des Anspruchs 1.

Ein Gerät dieser Art ist in der DE-OS 37 19 148 beschrieben und dargestellt. Bei diesem bekannten Gerät werden an einem umlaufenden Band angeordnete Träger mit aus einem Stangenmagazin rutschenden IC's beladen, einer Prüfvorrichtung zugeführt, an der die sich in den Trägern befindlichen IC's geprüft werden, und dann zu einer Entladestelle bewegt, wo die IC's entladen und zu Magazinstangen zwecks Befüllung derselben weiterbefördert werden. Dabei erfolgt sowohl die Übergabe vom Stangenmagazin zu den Trägern als auch die Entnahme aus den Trägern durch Rutschen aufgrund der Schwerkraft der IC's in Führungen. Aufgrund dieses Förderprinzips ist eine bestimmte Anordnung der Geräteteile zueinander vorgegeben, da das die IC's aufnehmende Geräteteil immer tiefer angeordnet werden muß als das abgebende Geräteteil. Aufgrund dieser Notwendigkeit ist bei dem bekannten Gerät die Durchgangsrichtung für die IC's durch das Gerät nicht änderbar. Deshalb ist das bekannte Gerät auch nicht in der Lage, entgegen seiner Durchlaufrichtung betrieben zu werden.

Außerdem ist der Einsatz des bekannten Geräts auf die Entnahme der IC's aus einem Stangenmagazin beschränkt, da eine andere Überführung als durch Rutschen nicht möglich ist. Es ist z.B. auch nicht möglich, IC's aus einem sogenannten Tray zu entnehmen. Aufgrund der Förderung durch Rutschen sind auch Störungen beim Durchlauf nicht auszuschließen. Ein Hängenbleiben eines IC's kann somit den Ausfall des Gerätes herbeiführen.

Ein IC ist ein typisches Massenprodukt, deshalb werden an ein vorliegendes Gerät auch hohe Anforderungen an dessen Leistungsfähigkeit gestellt.

Der Erfindung liegt die Aufgabe zugrunde, ein Gerät der eingangs bezeichneten Art so auszugestalten, daß bei Gewährleistung einer hohen Durchlaufleistung ein störungsfreier Durchlauf ohne eine Abhängigkeit der Ein- und Ausgangshöhen möglich ist.

Diese Aufgabe wird durch die kennzeichnenden Merkmale des Anspruchs 1 gelöst.

Bei der erfindungsgemäßen Ausgestaltung kommen zwei Greifer zum Aufnehmen und zum Abgeben der IC's vom Einsatz, die im Sinne von "shake hands" funktionieren sowie dabei höhenlagenunabhängig arbeiten können und bei kurzen Einzel-bzw. Taktwegen sowie sicherer Förderung gleichzeitig arbeiten. Hierdurch wird u.a. auch die Forderung nach hoher Leistungsfähigkeit erfüllt.

Vorteilhafte Weiterbildungen der Erfindung, die zu einfachen und kostengünstig herstellbaren Ausgestaltungen führen, die Funktion hinsichtlich der Sicherheit verbessern sowie aus Raumbedarfsgründen von Vorteil sind, sind in den Unteransprüchen beschrieben.

Nachfolgend wird die Erfindung anhand eines in einer Zeichnung dargestellten bevorzugten Ausführungsbeispiels näher erläutert: Es zeigt

Fig. 1 ein erfindungsgemäßes Gerät in der Seitenansicht und in vereinfachter Darstellung;

Fig. 2 das Gerät in der Draufsicht;

Fig. 3 einen Träger für ein IC in der Draufsicht und in vergrößerter Darstellung;

Fig. 4 den Träger in der Vorderansicht;

Fig. 5 die Teil-Ansicht V-V in Fig. 2.

Die wesentlichen Teile des mit 1 bezeichneten Gerätes sind eine Bereitstellungsvorrichtung 2 für IC's 3, eine erste Greifvorrichtung 4 mit zwei Greifern 5.1, 5.2 zum Ergreifen eines IC's 3 an einer Bereithaltungsstelle 6, wobei die Greifer 5.1, 5.2 zwischen der Bereithaltungsstelle 6 und einer Übergabestelle 8 hin und her bewegbar sind, eine zweite Greifvorrichtung 9 mit ebenfalls zwei Greifern 11.1, 11.2, zum Ergreifen eines IC's 3 an der Übergabestelle 8, wobei die Greifer 11.1, 11.2 zwischen der Übergabestelle 8 und einer Abgabestelle 12 hin und her bewegbar sind, und eine Träger-Bereithaltungsvorrichtung 13, in der mit IC's 3 zu beladende Träger 14 an der Abgabestelle 12 bereitgehalten werden. Die Bereithaltungsvorrichtung 13 weist eine Übergabevorrichtung 16 zur Übergabe der Träger 14 von einer Träger-Zuführung 17 an die Träger-Bereithaltungsvorrichtung 13 sowie eine Übergabevorrichtung 18 für die Übergabe der Träger 14 von der Träger-Bereithaltungsvorrichtung 13 in eine Träger-Abführung 19.

Das Gerät 1 dient somit dazu, IC's 3 an der Bereithaltungsstelle 6 zu entnehmen und an der Abgabestelle 12 in einen Träger 14 einzusetzen. Außerdem können mit dem Gerät 1 die IC's 3 aus den Trägern 14 entnommen und an der Bereithaltungsstelle 6 abgegeben werden, was noch beschrieben wird.

Die Bereithaltungsvorrichtung 2 weist einen Tragtisch 21 auf, der in zwei rechtswinklig zueinander verlaufenden Verstellrichtungen, nämlich einer X- und eine Y- Koordinate verstellbar und in der jeweiligen Verstellposition feststellbar ist. Hierzu dienen zwei Verstellvorrichtungen, bei der vorliegenden Ausgestaltung zwei Hydrozylinder 22, 23, deren eine in der einen Verstellrichtung bewegbarer Kolbenstange am Tragtisch 21 angreift, und deren andere, in die andere Verstellrichtung verstellbarer Kolbenstange an einem dem Tragtisch 21 tragenden Führungsschlitten 24 angreift. Ein Traggestell für den Führungsschlitten 24 ist aus Vereinfachungsgründen nicht dargestellt. Auf dem Tragtisch 21 kann ein viereckiges Tray 25 abgelegt und fixiert werden, daß eine Vielzahl Lagerstellen 26 für IC's 3 aufweist, die in mit den X- und Y-Koordinaten übereinstimmenden Reihen angeordnet sind. Den Hydrozylindern 22, 23 ist eine nicht dargestellte Steuerungsvorrichtung zugeordnet, die es ermöglicht, den Tragtisch 21 so zu verstellen, daß jede Lagestelle 26 vorzugsweise der Reihe nach zur Bereithaltungsstelle 6 verfahren werden kann.

Die Greifer 5.1, 5.2, 11.1, 11.2 der ersten und zweiten Greifvorrichtung 4, 9 weisen jeweils einen Sauggreifer auf, der jeweils am freien Ende einer Führungsstange 32 gehalten ist, die in einem Gehäuse 33 längsverschiebbar gelagert und durch eine nicht dargestellte Feder in ihre eingeschobene Stellung beaufschlagt ist. Es sind jeweils wenigstens zwei einander diametral gegenüberliegende Gehäuse 33 mit Führungsstangen 32 an einem um eine vertikale Drehachse drehbaren Rotor angeordnet, wobei die Rotoren diskontinuierlich so gedreht werden, daß in einem Arbeitstakt die Sauggreifer 5.1, 5.2 von der Bereithaltungsstelle 6 zur Übergabestelle 8 und die Sauggreifer 11.1, 11.2 von der Übergabestelle 8 zur Abgabestelle 12 und jeweils zurück bewegt werden. Nach jedem Arbeitstakt verharren die Rotoren 34, 35 für eine für das Ergreifen eines IC's 3 oder für das Abgeben eines IC's 3 an der Abgabestelle 12 erforderliche Zeit.

In die erste Greifvorrichtung 4 bzw. in deren Rotor 34 ist eine Wendevorrichtung 37 integriert, die es ermöglicht, das ergriffene IC 3 um 180° zu wenden, so daß die Unterseite des IC's 3 an der Bereithaltungsstelle 6 an der Übergabestelle 8 nach oben weist. Der Rotor 34 weist ein sich um die Rotorachse 38 drehendes Lagergehäuse 39 auf, in dem einander diametral gegenüberliegend zwei Wendewellen 41 gelagert sind, die radial aus dem Lagergehäuse 39 herausragen und an ihren freien Enden die Gehäuse 33 tragen. Auf dem Axialteil 42 des Lagergehäuses 39 ist ein Kegel-Antriebszahnrad 43 stationär gelagert, das mit jeweils einem Kegel-Abtriebsrad 44 kämmt, die mit den Wendewellen 41 oder den Gehäusen 33 verbunden sind und deshalb mit diesen drehen. Die Zähnezahlen der Zahnräder 43, 44 sind einander gleich. Infolgedessen drehen sich die Abtriebsräder 44 mit den Gehäusen 33 um 180°, wenn der Rotor 34 eine halbe Drehung ausführt und dabei den betreffenden Greifer 5.1 von der Bereithaltungsstelle 6 zur Übergabestelle 8 sowohl in der horizontalen als auch in der vertikalen Ebene schwenkt.

Der Rotor 35 der zweiten Greifvorrichtung 9 weist einen diametralen Schwenkarm 45 auf, der an seinen freien Enden die Gehäuse 33.1 trägt. Der Rotor 35 wird mit gleicher Geschwindigkeit angetrieben und so gesteuert, daß seine Schwenktakte mit den Schwenktakten des Rotors 34 übereinstimmen.

Die Träger-Bereithaltungsvorrichtung 13 weist einen um eine vertikale Drehachse 46 drehbaren Rotor 47 mit vier Dreharmen oder einer Drehscheibe 48 auf, auf der jeweils um 90° zueinander versetzt angeordnet vier Aufnahmevorrichtungen 49 für Träger 14 angeordnet sind. Der Rotor 47 dreht sich mit den Rotoren 34, 35 im gleichen Takt, jedoch mit der halben Winkelgeschwindigkeit, so daß bei jedem Schwenktakt von der Aufnahme-Übergabestelle 51 zur Abgabestelle 12 bzw. von dieser zur Abgabe-Übergabestelle 52 geschwenkt wird. Neben den Übergabestellen 51, 52 ist die jeweils zugehörige Zuführung bzw. Abführung 17, 19 angeordnet, die an einen Träger-Förderkreislauf angeschlossen sein können oder bei denen es sich auch um Stangenmagazine handeln kann, die sich in einer horizontalen, schrägen, schräggebogenen (Andeutungsweise dargestellt) oder vertikalen Position erstrecken können.

Die einander gleich ausgebildeten Aufnahmevorrichtungen 49 weisen zur Halterung der Träger 14 Führungselemente auf, die mit Führungselementen am Träger 14 zusammenwirken, vorzugsweise Hintergreifen. Die Führungselemente der Drehscheibe 48 sind T-förmig hinterschnittene Führungsstege 53, auf die die Träger 14 mit entsprechend T-förmigen Führungsnuten 54 an ihrer Unterseite aufschiebbar sind. Damit auch größere Träger 14 für größere IC's 3 bei gleicher Auführung der Führungsstege 53 und Führungsnuten 54 aufgenommen werden können, sind die Führungsstege 53 länger bemessen, als die Träger 14. Zur Begrenzung der Übergabebewegung ist am radial inneren Ende jedes Führungsstegs 53 ein Begrenzungsanschlag 55 durch eine parallel zum Führungssteg 53 angeordnete Einstellschraube gebildet, die einen Ansatz am Führungssteg 53 in einem Gewindeloch durchfaßt. Zur Sicherung des jeweils auf die Scheibe 48 übergebenen Trägers 14 in der Übergabeposition ist ein andeutungsweise dargestelltes Stoppelement 56 vorgesehen, das von unten die Drehscheibe 48 durchfaßt und gegen den übergebenen Träger 14 drückt, damit dieser unter Bewegung der Fliehkraft beim Drehen des Rotors 47 nicht verrutscht. An der Abgabe-Übergabestelle 52 wird das z.B. pneumatisch betriebene Element 56 wieder gelöst.

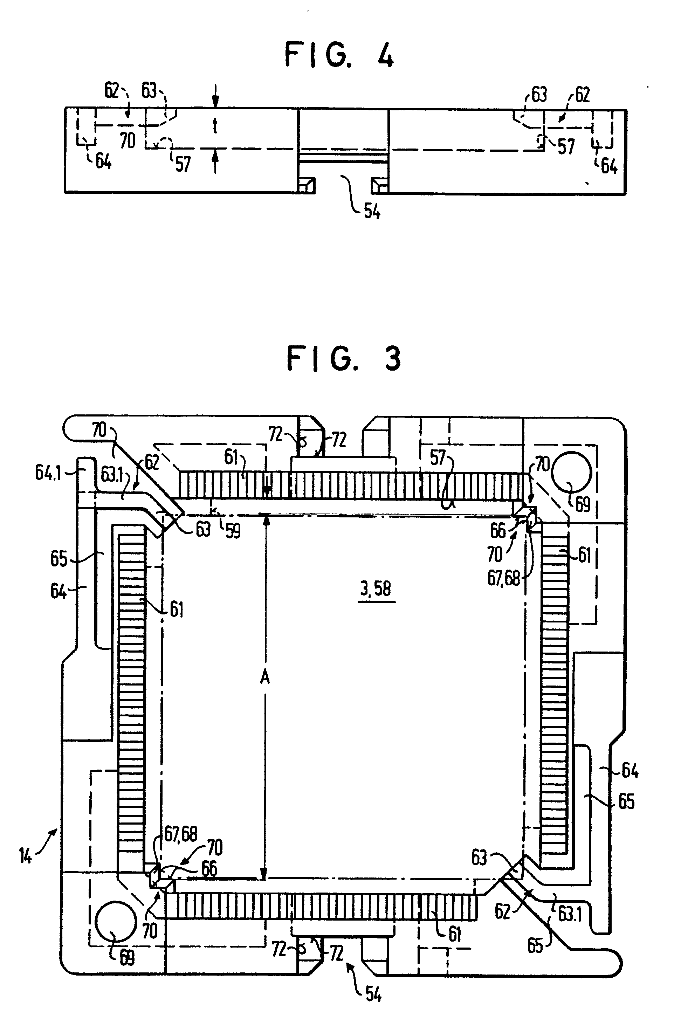

Die Träger 14 sind durch gleiche, plattenförmige und auf der Drehscheibe 48 flach angeordnete Körper rechteckiger Form gebildet, die an ihrer Unterseite mittig und längs durchgehend die Führungsnut 54 und an ihrer Oberseite einen vertikalen Schacht 57 zur Aufnahme der IC's 3 aufweisen. Die Tiefe t des Schachts 57 entspricht etwa der Dicke des in der Fig. 3 dargestellten IC's 3. Der Schacht 57 ist an die Umfangsform der hierdurch quadratische Flachkörper 58 gebildeten IC's 3 angepaßt, die mit Ausnahme ihrer Ecken auf ihrem gesamten Umfang sich quer zur Umfangsfläche erstreckende Kontaktelemente 59 in Form von Drähten aufweisen. Die Kontaktelemente 59 befinden sich an der Ober- bzw. Bauchseite der IC's 3, und sie tauchen in der eingesetzten Position des IC's in sich quer zum Umfang des Schachtes 57 erstreckende Ausnehmungen oder Riefen 61 am Rand des Schachtes 57 ein, wo sie sicher und beschädigungsfrei aufgenommen sind. Gegen Herausfallen aus dem Schacht 55 ist das IC 3 durch zwei biegsame Sicherungsarme 62 gesichert, die an zwei aneinander gegenüberliegenden Ecken des Schachtes 57 diagonal durch Öffnungen in der Schachtwand in den Schacht 57 hineinragen und dabei die zugehörigen Ecken des IC's 3 vorzugsweise mit Schrägflächen geringfügig übergreifen. Die Sicherungsarme 62 weisen jeweils einen diagonalen Armteil 63 und einen parallel zum Umfang des Trägers 14 und dabei einen stumpfen Winkel mit dem Armteil 63 einschließenden Armteil 64 auf, der vom Körper des Trägers 14 vorzugsweise einstückig ausgeht. Die Armteile 64 sind über Armteilstücke 63.1 hinaus verlängert, die sich rechtwinklig zu den Armteilen 64 erstrecken. Die Verlängerungen sind mit 64.1 bezeichnet. Die Träger 14 bestehen vorzugsweise aus Kunststoff und sind einstückige Druckguß- oder Spritzgußteile, die zum Zweck der Gewichtsverminderung mehrere Aussparungen bzw. Freiräume aufweisen. In solchen Freiräumen 65 sind auch die Sicherungsarme 62 elastisch biegbar angeordnet.

Dem Schacht 57 ist eine besondere vertikale Führung für die IC's 3 zugeordnet, um Beschädigungen der mit Ausnahme im Bereich der Ecken angeordneten Kontaktelemente 59 der IC's 3 beim Einsetzen in den Träger 14 oder beim Herausnehmen zu vermeiden. Hierzu ist zwischen den einander gegenüberliegenden Schachtwänden und dem Umfang des IC's 3 ein Spalt b vorgesehen. An den beiden anderen Ecken, die zwischen den Sicherungsarmen 62 liegen, ist ein vertikaler Führungsvorsprung 70 mit einer vertikalen winkelförmigen Führungsnut 66 angeordnet, deren Form und Abstand voneinander der Form und dem Abstand der zugehörigen Ecken bzw. der Abmessung A des IC's 3 unter Berücksichtigung eines Bewegungsspiels entspricht. Infolgedessen ist das IC 3 lediglich an den beiden winkelförmigen, oberseitig vorzugsweise angeschrägten Führungsflanken 67 und somit nur im Bereich der bzw. dieser Ecken geführt, wo keine Kontaktelemente 59 vorhanden sind. Die Führungsflanken 67 weisen oberseitig Einführungsschrägen 68 auf. Im Bereich der einander gegenüberliegenden, die Sicherungsarme 62 nicht enthaltenden Ecken jedes Trägers 14 ist je ein rundes Zentrierloch 69 zum Zentrieren des Trägers 14 an der Abgabestelle 12 vorgesehen, in die angespitzte senkrechte Zentrierstifte (nicht dargestellt) an den Greifern 11.1, 11.2 mit geringem Bewegungsspiel einfassen. An den Enden der Nut 54 ist der Träger 14 nach oben durch je eine Ausnehmung 72 ausgespart. Dies ist nicht nur aus spritzgießtechnischen Gründen von Vorteil, sondern es wird auch Freiraum geschaffen für Zentrierwerkzeuge an den Greifern 11.1, 11.2 zum Zentrieren des IC's 3 an der Übergabestelle.

Die Zuführung und Abführung 17, 19 oder das Zuführungs-Magazin und das Abführungs-Magazin weisen jeweils einen der Führungsnut 54 entsprechenden Führungssteg 75 auf und können dabei durch eine entsprechend ausgestaltete Schiene gebildet sein. Es sind aber auch sowohl für die Zu- und Abführung 17, 19 als auch für die Führungselemente auf der Drehscheibe 48 übliche Führungskanäle, in denen die Träger 14 an Führungsflächen, vorzugsweise den Umfangsflächen, geführt sind, möglich.

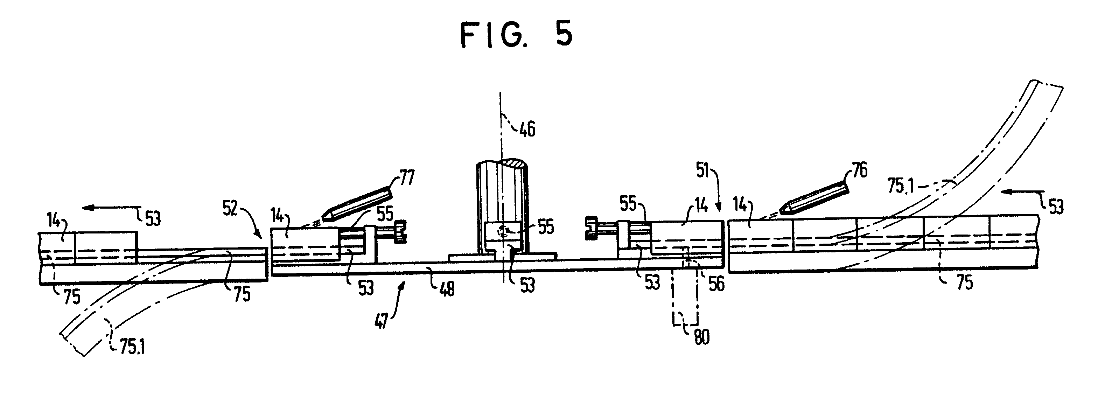

Die Zuführung zu und Abführung der Träger 14 aus den Aufnahmevorrichtungen 49 kann durch geeignete Antriebs- bzw. Verschiebevorrichtungen erfolgen. Die Zuführung und Abführung kann auch unter Ausnutzung der Schwerkraft der Träger 14 erfolgen, wenn die Magazine bzw. Führungsstege 75 von der Waagerechten abweichen, insbesondere aufwärts oder abwärts gekrümmt sind, wie es in Fig. 5 dargestellt ist.

Bei der vorliegenden Ausgestaltung werden die Träger 14 an den Übergabestellen 51, 52 mittels Druckluft verschoben, wozu Druckluftdüsen 76, 77 dienen. Wie aus Fig. 5 zu entnehmen ist, kann die Zuführungs-Düse 76 im Endbereich oberhalb der Zuführung 17 angeordnet sein, wobei sie sich auch geneigt erstrecken kann. Wesentlich ist, daß sie eine auf den Führungssteg 53 gerichtete Druckluft-Strömung zur Zeit der Übergabe wenigstens kurzzeitig auf dem vordersten in der Zuführung 17 befindlichen Träger 14 abgibt. Die Abführungs-Düse 77 ist an der Abgabe-Übergabestelle 52 über der Aufnahmevorrichtung 49 angeordnet, wobei ihr Druckluftstrahl schräg nach außen auf den sich darin befindlichen Träger 14 gerichtet ist. Die Düsen 76, 77 sind so gesteuert, daß sie während der Stillstandzeit der Drehscheibe 48 einen vorbestimmten Druckluftimpuls abgeben zur Übergabe der Träger 14 in bzw. aus den Aufnahmevorrichtungen 49. Hierdurch ist ein einfacher und schneller Antrieb für die Träger 14 vorgegeben. Insbesondere bei der Druckluftzuführung wird aufgrund des auf den betreffenden Träger 14 wirksamen Luftströmung ein Rückprall des Trägers vom mit 55 bezeichneten Anschlag verhindert.

Es ist vorteilhaft, den auf den Führungssteg 53 aufgeschobenen Träger 14 gegen radiale Verschiebung zu sichern, damit er sich bei dem nächsten Dreh- oder Schwenktakt der Drehscheibe 48 aufgrund der dann wirksamen Fliehkraft nicht nach außen bewegt. Dies kann durch pneumatische Druckzylinder 80 erfolgen, von denen in Figur 5 einer Andeutungsweise dargestellt ist, er unterseitig an der Drehscheibe 48 gehalten ist und dessen Kolbenstange die Drehscheibe 48 und gegebenenfalls den Führungssteg 53 durchfaßt und den betreffenden Träger 14 quer zum Führungssteg 53 im Sinne eines Stoppelements festklemmt.

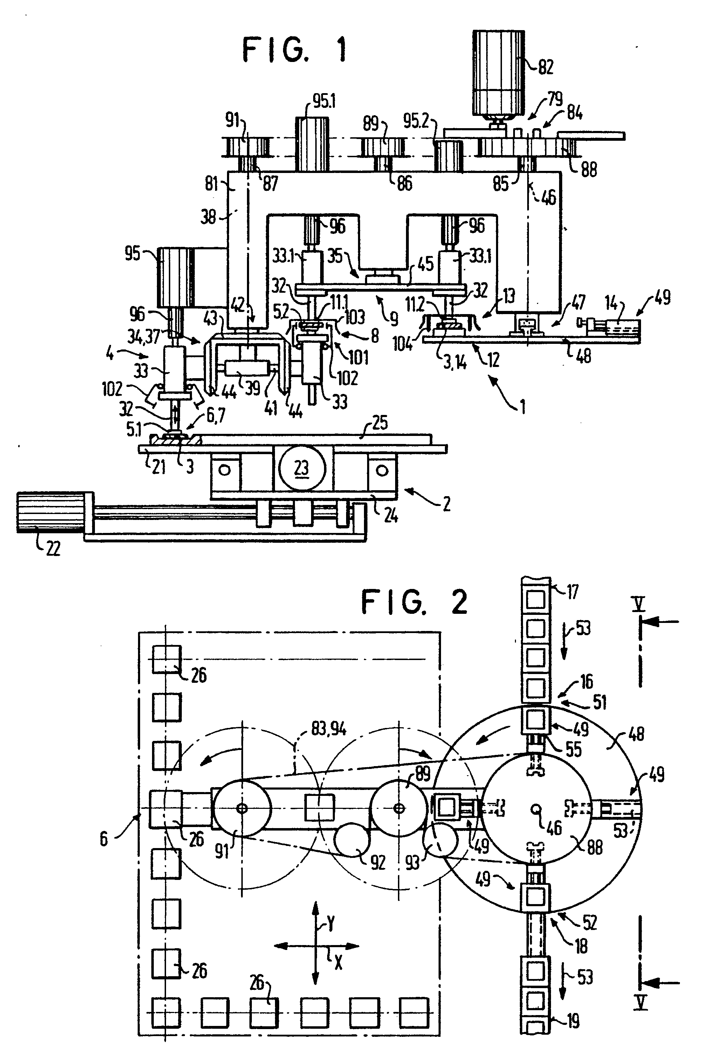

Den Rotoren 34, 35 und 47 ist ein gemeinsamer Antrieb 79 zugeordnet, der oberseitig eines die Rotoren ebenfalls lagernden Geräterahmens 81 angeordnet ist. Der Antrieb 79 umfaßt einen Antriebsmotor 82, einen für alle drei Rotoren 34, 35, 47 gemeinsamen Riementrieb 83 und ein allgemein mit 84 bezeichnetes Getriebe zwischen dem Antriebsmotor 82 und dem Riementrieb 83 zu dessen intermittierenden Antrieb, das bei der vorliegenden Ausgestaltung durch ein Malteserkreuz-Getriebe 84 gebildet ist, das vereinfacht nur in Fig. 1 dargestellt ist. Auf den oberen Enden der Rotorwellen 85, 86, 87 sind Riemenscheiben 88, 89, 91 befestigt, von denen der Durchmesser der Riemenscheibe 88 des Rotors 47 doppelt so groß bemessen ist, wie die beiden gleich groß bemessenen Durchmesser der Riemenscheiben 89, 91 der Rotoren 34, 35. Hierdurch ist ein Übersetzungsverhältnis von 1:2 zwischen dem Rotor 47 und den Rotoren 34, 35 vorgegeben. Infolgedessen dreht der Rotor 47 bei einem Arbeitstakt nur um 90°, während die Rotoren 34, 35 jeweils um 180° drehen. Zwecks Schaffung eines ausreichenden Umschlingungswinkels für die mittlere Riemenscheibe 89 sind in an sich bekannter Anordnung zwei Stützrollen 92, 93 zu beiden Seiten der mittleren Riemenscheibe 89 vorgesehen, um die der Flach- oder Keil-Riemen 94 umläuft.

Für den Antrieb der Sauggreifer 5.1, 5.2, 11.1, 11.2 jeweils aus der Bereitschaftsstellung, in der die zugehörige Führungsstange 32 in das Gehäuse 33 eingeschoben ist, und der ausgeschobenen Greifstellung ist jeweils eine Schubvorrichtung vorgesehen, die bei der vorliegenden Ausgestaltung durch einen oberhalb jedes Gehäuses 33 an der Aufnahmestelle 7, Übergabestelle 8 und Abgabestelle 12 jeweils angeordneten Arbeitszylinder 95, 95.1, 95.2 mit einer nach unten weisenden Kolbenstange 96 gebildet ist, die durch Druck auf das das zugehörige Gehäuse 33 oberseitig durchragende Ende der zugehörigen Führungsstange 32 diese aus ihrer Bereitschaftsstellung in ihre Greifstellung verschiebt.

Nachfolgend wird die Funktion des Gerätes 1 beschrieben. In der bereits dargestellten Arbeitsstellung ergreift der Greifer 5.1 ein IC 3 aus dem Tray 25, der Greifer 5.2 ergreift ein IC 3 an der Übergabestelle 8 und der Greifer 11.2 gibt ein IC 3 an der Abgabestelle 12 in den in der betreffenden Aufnahmevorrichtung 49 befindlichen Träger 14 ab. Nach dem Ergreifen oder Abgeben der IC's 3 werden die Führungsstangen 32 mit den zugehörigen Kolbenstangen 96 in ihre Bereitschaftsstellung eingefahren. Anschließend werden die Rotoren 34, 35, 47 um einen Arbeitstakt gedreht, wobei der das IC 3 vom Tray 25 entnommene Greifer 5.1 zugleich um die Rotorachse 38 und die Wendewellen 41 gedreht wird, so daß der Greifer 5.1 und das darin gehaltene IC 3 mit seinem Bauch nach oben zeigen und zwar in der Übergabestelle 12. Gleichzeitig ist die Führungsstange 32 eingefahren worden, und es ist auch eine der beiden Greifer 11.1, 11.2 in seine Übergabestellung gedreht worden, in der er nach dem Ausfahren der zugehörigen Führungsstange 32 durch den zugehörigen Arbeitszylinder 95.2, 95.3 das an der Übergabestelle 8 befindliche IC 3 am Bauch zu ergreifen vermag. Der Übergabestelle 8 ist eine Ausrichtvorrichtung 101 zum Ausrichten des IC's 3 an der Übergabestelle 8, nämlich im Greifer 5 vorgesehen. Die Ausrichtung ist möglich, weil der Greifer 5 ein Sauggreifer ist und deshalb das IC 3 quer zur Achse des Greifers 5 ausgerichtet bzw. verschoben werden kann. Die Ausrichtvorrichtung 101 umfaßt Ausricht-Schwenkarme 102, die am Gehäuse 33 der ersten Greifvorrichtung so schwenkbar gelagert sind, daß sie in der eingeschobenen Stellung der zugehörigen Führungsstange 32 seitlich gegen das im Greifer 5 befindliche IC 3 stoßen und das IC 3 somit ausrichten können. Beim vorliegenden Ausführungsbeispiel weist die Ausrichtvorrichtung 101 ein mit den Schwenkarmen 102 zusammenwirkendes Aktivierungselement 103 auf, das am Greifer 11 der zweiten Greifvorrichtung 9 gehalten ist und beim Ausfahren des Greifers 9 in Kontakt mit den Schwenkarmen 102 kommt und diese zwecks Ausrichtung aktiviert. Beim vorliegenden Ausführungsbeispiel sind vier Schwenkarme (auf jeder Seite ein Schwenkarm) in L- oder U-förmiger Form angeordnet, die mit ihren aufeinanderzugerichteten Schenkeln das dem jeweiligen Greifer 5 zugewandte Ende des Gehäuses 33 übergreifen. In ihrer Ausschwenkbewegung sind die Schwenkarme 102 begrenzt, und zwar derart, daß das haubenförmig oder aus vier kreuzweise angeordneten U-förmigen Armen bestehende Aktivierungselement mit nach unten divergierenden Schrägkanten oder Schrägflächen beim Herunterschieben des betreffenden Greifers 5 die Schwenkarme 102 mit den Schrägflächen zu einer Einwärtsbewegung zwecks Ausrichtens zwingt. Während der Wartezeit des Greifers 5 an der Übergabestelle 8 kann die Greifer-Saugluft in Funktion oder auch abgeschaltet sein. Vorzugsweise beim Herunterschieben des zugehörigen Greifers 11 wird dessen Saugluftbetrieb eingeschaltet. Spätestens zu diesem Zeitpunkt ist der Saugluftbetrieb des Greifers 5 einzuschalten, so daß der Greifer 11 das an seinem Bauch 3 angesaugte IC beim Hochfahren des Greifers 11 anzuheben vermag. Beim nächsten Arbeitstakt wird der Rotor und somit auch das aufgenommene IC 3 um 180° in die Abgabestellung gedreht. In dieser Position befindet sich das IC 3 über dem Schacht 57 eines im gleichen Arbeitstakt von der Zuführung 17 zur Abgabestelle 12 geförderten Trägers 14 in der zugehörigen Aufnahmevorrichtung 49. Vor dem Einsetzen des IC's 3 in den Träger 14 durch Herunterschieben des Greifers 11.1 werden die Sicherungsarme 62 am Träger 14 auseinander gedrückt, um den freien Eingang des IC's 3 in den Schacht 55 zu gewährleisten. Dieses Spreizen der Sicherungsarme 62 erfolgt durch eine dem Aktivierungselement 103 zugeordnete Spreizvorrichtung, die beim vorliegenden Ausführungsbeispiel durch zwei einander gegenüberliegende vertikale Spreizstifte 104 mit Schrägflächen an ihren freien Enden, die beim Herunterschieben des Greifers 11.1 und somit auch der Spreizstifte 104 mit ihren Schrägflächen die Sicherungsarme 62 auseinander drücken. Sobald das IC 3 eingesetzt ist, wird der Saugluftbetrieb des Greifers 11.1 abgeschaltet und der Greifer 11.1 zu seiner Ausgangsstellung wieder hochgeschoben. Während dieser Zeit hat der andere Greifer 11.2 an der Übergabestelle bereits ein IC 3 in der vorbeschriebenen Weise übernommen. Nunmehr wird ein neuer Arbeitstakt ausgeführt, bei dem der leere Greifer 11.1 zur Übergabestelle 8 und der Greifer 11.2 in die Abgabestellung geschwenkt werden. Gleichzeitig wird die Drehscheibe 48 um 90° gedreht, wodurch der mit dem IC 3 beladene Träger 14 zur Abgabe-Übergabestelle 52 und ein unbeladener Träger 14 von der Aufnahme-Übergabestelle 51 zur Abgabestelle 12 gelangt. Während des Beladevorgangs des nun an der Abgabestelle 12 befindlichen Trägers wird der nächste in der Zuführung 17 befindliche Träger 14 mit der Druckluft in die zugeordnete Aufnahmevorrichtung 49 eingeblasen und gleichzeitig wird der beladene Träger 14 an der Abgabe-Übergabestelle 52 radial in die Abführung 19 herausgeblasen. Vorher ist natürlich der pneumatische Druckluftzylinder 80 abzuschalten, um den Träger 14 freizugeben.

Da die Drehscheibe 48 vier Stationen aufweist, von denen im vorbeschriebenen Takt nur drei Stationen benötigt werden, ergibt sich eine Leerstation, die für andere Zwecke, insbesondere Prüfzwecke verwendet werden kann. In einem solchen Fall kann die Abgabe-Übergabestellung 52 der Abgabestelle 12 nicht benachbart sondern gegenüberliegend angeordnet werden, wobei an der Übergabestelle 52 eine nicht dargestellte Prüfvorrichtung angeordnet wird.

Wie schon erwähnt, eignet sich das Gerät nicht nur zum vollautomatischen Beladen von Trägern 14, sondern auch zum vollautomatischen Entladen. Dies erfolgt in umgekehrter Durchlaufrichtung, wobei die Aufnahmestelle 7 und die Abgabestelle 12 miteinander wechseln. Die IC's 3 werden mit dem jeweiligen Greifer 11.1, 11.2 aus dem jeweiligen Träger 14 entnommen, wobei vor dem Herausnehmen nach oben durch Saugluftbetrieb des betreffenden Greifers die Sicherungsarme 62 beim Herunterschieben des betreffenden Greifers gespreizt werden, so daß das im betreffenden Träger 14 befindliche IC störungsfrei nach oben entnommen werden kann. An der Übergabestelle 8 wird das entnommene IC dem Greifer 5.1, 5.2 der ersten Greifvorrichtung 4 übergeben, der sich gerade an der Übergabestelle 8 befindet. In entsprechend umgekehrter Weise werden die IC's dann auch in das Tray 25 abgelegt, das entsprechend verfahren wird. Beim Entladen ist der Saugluftbetrieb der Greifer entsprechend der umgekehrten Funktion zu steuern. Die betreffende Steuervorrichtung ist aus Vereinfachungsgründen nicht dargestellt.

Im Rahmen der Erfindung können ein Tray 25 mit einem entsprechend eingerichteten Tragtisch 21 auch andere Bereitstellungsvorrichtungen 2 bzw. Abführungsvorrichtungen zum Einsatz kommen.

## Ansprüche

1. Gerät (1) zum Beladen und/oder Entladen von Trägern (14) mit elektronischen Bauelementen (3), insbesondere IC's,
dadurch **gekennzeichnet,**
daß eine erste Greifvorrichtung (4) mit einem Greifer (5) vorgesehen ist, die im Beladebetrieb zur Aufnahme eines Bauelements (3) an einer Aufnahmestelle (7) und Förderung sowie Bereithaltung des Bauelements (3) an einer Übergabestelle (8) dient, und daß eine zweite Greifvorrichtung (9) mit einem Greifer (11) vorgesehen ist, die im Beladebetrieb zur Übernahme des Bauelements (3) an der Übergabestelle (8) sowie Förderung und Abgabe des Bauelements (3) an einen an der Abgabestelle (12) bereitgestellten Träger (14) dient.

2. Gerät nach Anspruch 1,
dadurch **gekennzeichnet,**
daß der ersten und der zweiten Greifvorrichtung (4, 9) jeweils zwei Greifer (5.1, 5.2, 11.1, 11.2) zugeordnet sind, die abwechselnd zum Einsatz kommen und gleichzeitig gegensätzlich bewegt werden.

3. Gerät nach Anspruch 1 oder 2,
dadurch **gekennzeichnet,**
daß die Greifer (5.1, 5.2, 11.1, 11.2) vertikal verschiebbar sind und sich zum Aufnehmen und Abgeben der Bauelemente (3) in ihren ausgeschobenen Stellungen befinden.

4. Gerät nach Anspruch 3,
dadurch **gekennzeichnet,**
daß der das Bauelement (3) an der Übergabestelle (8) abgebende Greifer (5) der ersten Greifvorrichtung sich an der Übergabestelle in seiner eingeschobenen Stellung befindet.

5. Gerät nach wenigstens einem der Ansprüche 1 bis 4,

dadurch **gekennzeichnet,**

daß die Greifer (5.1, 5.2, 11.1, 11.2) Sauggreifer sind.

6. Gerät nach wenigstens einem der Ansprüche 1 bis 5,

dadurch **gekennzeichnet,**

daß die Greifer (5.1, 5.2, 11.1, 11.2) an um vertikale Drehachsen drehbare und intermittierend angetriebene Rotoren (34, 35) angeordnet sind.

7. Gerät nach Anspruch 6,

dadurch **gekennzeichnet,**

daß die Rotoren pro Arbeitstakt eine Drehung um 180° ausführen.

8. Gerät nach wenigstens einem der Ansprüche 1 bis 7,

dadurch **gekennzeichnet,**

daß in eine der beiden Greifvorrichtungen (4, 9) eine Wendevorrichtung (37) für die Bauelemente (3) integriert ist.

9. Gerät nach wenigstens einem der Ansprüche 6 bis 8,

dadurch **gekennzeichnet,**

daß die Rotoren (34, 35) seitlich versetzt übereinander angeordnet sind.

10. Gerät nach Anspruch 9,

dadurch **gekennzeichnet,**

daß an der Übergabestelle die dort befindlichen Greifer (5.11) der ersten und zweiten Greifvorrichtung (4, 9) senkrecht übereinander angeordnet sind und daß vorzugsweise die Aufnahmestelle (7), die Übergabestelle (8) und die Abgabestelle (12) in einer in den Drehachsen der Rotoren (34, 35) liegenden Vertikalebene liegen.

11. Gerät nach wenigstens einem der Ansprüche 1 bis 10,

**gekennzeichnet** durch

eine Zentriervorrichtung (101) für das Bauelement (3) an der Übergabestelle.

12. Gerät nach Anspruch 11,

dadurch **gekennzeichnet,**

daß an dem sich an der Übergabestelle befindlichen, das Bauelement (3) abgebenden Greifer (5) Zentrierelemente (102) vorgesehen sind, die mit an dem das Bauelement (3) übernehmenden Greifer (9) angeordnete Zentrierelemente (103) zusammenwirken, vorzugsweise von diesem aktiviert werden.

13. Gerät nach wenigstens einem der Ansprüche 1 bis 12,

dadurch **gekennzeichnet,**

daß die Greifer (5, 11) an Schubstangen (32) angeordnet sind und über der Aufnahmestelle (7), Übergabestelle (8) und Abgabestelle (12) Antriebsvorrichtungen, vorzugsweise in Form von angetriebenen Kolbenstangen (96) angeordnet sind zum Ausschieben der Schubstangen (32) in der Arbeitsstellung.

14. Gerät nach wenigstens einem der Ansprüche 1 bis 13,

dadurch **gekennzeichnet,**

daß an der Abgabestelle (12) eine im Takt der Greifer (5, 11) intermittierend automatisch arbeitende Zuführungs- und Abführungsvorrichtung für Träger (14) vorgesehen ist.

15. Gerät nach Anspruch 14,

dadurch **gekennzeichnet,**

daß die Zuführungs- und Abführungsvorrichtung ein intermittierend umlaufendes Teil (48) mit wenigstens drei Stationen aufweist, das in einer Transportbahn (17, 19) für die Träger (14) angeordnet ist, wobei zwischen der Transportbahn (17, 19) und dem Teil (48) Übergabevorrichtungen (51, 52) für die Träger (14) vorgesehen sind.

16. Gerät nach Anspruch 15,

dadurch **gekennzeichnet,**

daß das Teil eine Drehscheibe (48) ist.

17. Gerät nach Anspruch 15 oder 16,

dadurch **gekennzeichnet,**

daß die Träger (14) mittels einer Druckluftströmung auf das Teil (48) und von diesem geschoben werden.

18. Gerät nach wenigstens einem der Ansprüche 1 bis 17,

**gekennzeichnet** durch

eine an der Abgabestelle (12) wirksame Zentriervorrichtung für die Träger (14) mit Zentrierelementen (69) am Träger (14) und am Greifer (11) der zweiten Greifvorrichtung (9).

19. Gerät nach wenigstens einem der Ansprüche 1 bis 18,

**gekennzeichnet** durch

ein im Takt der Greifer (5, 11) automatisch arbeitende Bereithaltungsvorrichtung für Bauelemente (3) an der Aufnahmestelle (7).

20. Gerät nach Anspruch 19,

dadurch **gekennzeichnet,**

daß die Bereithaltungsvorrichtung durch einen in zwei Koordinatenrichtungen (X, Y) verstellbaren Tisch (21) mit einem darauf gehaltenen Tray (25) gebildet ist.

21. Gerät nach wenigstens einem der Ansprüche 1 bis 20,

dadurch **gekennzeichnet,**

daß die Steuerung und Funktion des Gerätes sowie die Durchlaufrichtung im Entladebrieb umgekehrt wie im Beladebetrieb sind.

FIG. 1

FIG. 2

# FIG. 4

# FIG. 3

# FIG. 5

EP 0 393 588 A2